# DEMANDE DE BREVET EUROPEEN

(11) **EP 3 323 912 A1**
(43) Date de publication de la demande: **23.05.2018**
(21) Numéro de dépôt: 17201372.4
(22) Date de dépôt: 13.11.2017
(51) Int. Cl.: C30B 25/20, C30B 29/06

(54) **SUIVI DE L'AVANCEMENT DE LA FUSION PAR TECHNIQUE LIBS LORS DE L'ÉLABORATION D'UN LINGOT PAR SOLIDIFICATION DIRIGÉE PAR REPRISE SUR GERMES**

(30) Priorité: 18.11.2016 FR 1661209
(71) Demandeur: Commissariat à l'Energie Atomique et aux Energies Alternatives, 75015 Paris (FR)
(72) Inventeur: PIHAN, Etienne, 73290 LA MOTTE SERVOLEX (FR); BENMANSOUR, Malek, 73290 LA MOTTE SERVOLEX (FR); PATATUT, Loïc, 73370 LE BOURGET DU LAC (FR)
(74) Mandataire: Nony

(57) **Abrégé**

L'invention concerne un procédé utile pour suivre l'avancement de la fusion lors de l'élaboration d'un lingot de silicium par solidification dirigée par reprise sur germes, comprenant au moins les étapes consistant en :
(i) disposer, dans un creuset, d'une charge de silicium positionnée en surface d'un ou plusieurs germes en silicium ;
le ou lesdits germes, et/ou ladite charge de silicium en une ou plusieurs position(s) donnée(s), comportant un ou plusieurs agents traceurs choisis parmi les agents dopants de type n ou de type p présentant un coefficient de partage dans le silicium inférieur ou égal à 10⁻¹ ; les éléments métalliques présentant un coefficient de partage dans le silicium inférieur ou égal à 10⁻⁴; et les éléments iso-électroniques du silicium germanium et étain ;
(ii) apprécier, au cours de la fusion de la charge de silicium, la présence et/ou la quantité en agent(s) traceur(s) par une technique de mesure chimique de type LIBS à la surface du bain de silicium fondu ; et
(iii) déterminer, à partir de la ou des mesures LIBS, l'avancement de la fusion.

## Description

La présente invention se rapporte à un nouveau procédé de suivi de l'avancement d'un cycle d'élaboration d'un lingot de silicium par solidification dirigée par reprise sur germes, plus particulièrement utile pour la détection de la fin de fusion.

Les lingots de silicium sont classiquement réalisés par fusion d'une charge de silicium, suivie de la cristallisation dirigée du silicium. Cette technique de solidification dirigée permet avantageusement de cristalliser de grands volumes de silicium, et d'ajuster la taille des lingots usinés en variant les dimensions des creusets.

Plus précisément, l'élaboration d'un lingot de silicium par reprise sur germes en four de solidification dirigée met en oeuvre les étapes suivantes.

Un germe ou pavage de germes de silicium, d'épaisseur connue, est positionné au fond d'un creuset, généralement en silice, graphite ou autre. Une quantité de silicium solide, appelée « charge », est ensuite disposée dans le creuset.

La fusion dirigée est déclenchée par le programme de chauffage du four. La fusion se propage du haut vers le bas de la charge, ce qui se traduit par un rapprochement progressif de l'interface solide/liquide du ou desdits germes tapissant le fond du creuset.

Lorsque le silicium est complètement en fusion, et que les germes commencent à fondre, le silicium est solidifié, de façon dirigée, à faible vitesse (typiquement de 5 à 30 mm par heure).

La réussite de la reprise sur germes dépend de la connaissance de la position de l'interface solide/liquide, en particulier de la prévision exacte de la position d'arrêt de la fusion. En effet, il est indispensable de maîtriser la position d'arrêt de la fusion, de manière à éviter la dissolution totale du ou des germes, l'initiation de la cristallisation n'étant possible que si le bain fondu est en contact de germes qui sont restés au moins en partie à l'état solide.

A ce titre, il est particulièrement déterminant de connaître l'avancée de l'interface solide/liquide, en particulier sa position en fin de fusion, avant le déclenchement de la solidification.

Actuellement, la détection de la fin de fusion est généralement réalisée par une opération de palpage mécanique à l'aide d'une canne en quartz. Ce palpage mécanique apporte l'information de la position de l'interface solide/liquide au cours de la fusion. L'information de la position de l'interface solide/liquide permet de déclencher au moment souhaité la transition du programme de fusion vers le programme de cristallisation du four.

Toutefois, cette méthode de détection par palpage, en plus d'être coûteuse, est une technique intrusive. Elle induit en particulier un risque de contamination du silicium lors du palpage, notamment par le quartz de la canne utilisée.

Cette méthode (manuelle ou éventuellement automatisable mécaniquement) nécessite en outre de prendre une référence initiale de la position de la surface des germes par rapport à un référentiel four (côte « zéro ») et induit une incertitude de mesure de la position de l'interface solide/liquide non négligeable.

Pour éviter une telle étape intrusive de palpage au cours du procédé de solidification dirigée du lingot, il a déjà été proposé de procéder à une mesure indirecte et sans contact de cette interface solide/liquide, *via* la connaissance de la position de l'interface gaz/liquide. On peut par exemple citer le document DE 102 34 250 qui propose de suivre l'avancée de la cristallisation d'un milieu, notamment du silicium, par mesure de l'évolution du volume du milieu au cours de la cristallisation, par exemple par mesure optique.

La présente invention vise à proposer une nouvelle méthode de suivi de l'avancée du front de fusion, permettant de s'affranchir de l'opération intrusive de palpage mécanique de l'interface solide/liquide.

Plus précisément, l'invention concerne, selon un premier de ses aspects, un procédé utile pour suivre l'avancement de la fusion lors de l'élaboration d'un lingot de silicium par solidification dirigée par reprise sur germes, comprenant au moins les étapes consistant en :
(i) disposer, dans un creuset, d'une charge de silicium positionnée en surface d'un ou plusieurs germes en silicium ;
   le ou lesdits germes, et/ou ladite charge de silicium en une ou plusieurs position(s) donnée(s), comportant un ou plusieurs éléments, dits agents traceurs, choisis parmi :
   - les agents dopants de type n ou de type p présentant un coefficient de partage dans le silicium inférieur ou égal à 10⁻¹ ;
   - les éléments métalliques présentant un coefficient de partage dans le silicium inférieur ou égal à 10⁻⁴ ; et
   - les éléments iso-électroniques du silicium, spécifiquement étain (Sn) et germanium (Ge) ;
(ii) apprécier, au cours de la fusion de la charge de silicium, la présence et/ou la quantité en agent(s) traceur(s) par une technique de mesure chimique de type spectroscopie sur plasma induit par laser (LIBS), à la surface du bain de silicium fondu ; et
(iii) déterminer, à partir de la ou des mesures LIBS, l'avancement de la fusion.

On entend plus particulièrement par « avancement de la fusion », la position de l'interface silicium solide/silicium liquide (ou fondu), encore appelée « front de fusion » dans le creuset lors de la fusion de la charge de silicium lors d'un cycle d'élaboration d'un lingot de silicium par reprise sur germes en four de solidification dirigée.

Les agents traceurs mis en oeuvre selon l'invention en vue d'identifier la position du front de fusion, sont désignés plus simplement dans la suite du texte sous l'appelation « traceurs ».

La méthode selon l'invention tire ainsi profit d'une technique d'analyse chimique non intrusive de type spectroscopie sur un plasma induit par laser (encore appelée « LIBS » pour « Laser Induced Breakdown Spectroscopy » en langue anglaise) du bain liquide, pour connaître l'état d'avancement du front de fusion.

La technique LIBS permet avantageusement une analyse *in situ* de la composition du bain de silicium fondu, sans nécessiter de prélèvement ni de contact, ainsi qu'une rapidité d'acquisition des informations.

La technique LIBS constitue une méthode analytique physique bien connue, typiquement utilisée pour permettre une analyse rapide, directe (sans préparation d'échantillons) et en ligne de matériaux sous forme solide, liquide ou gazeuse.

Elle met en oeuvre l'ablation-laser d'un matériau pour créer un plasma, puis la technologie spectroscopique pour l'observation et l'analyse du spectre lumineux du plasma afin de déterminer les composants du matériau.

Plus précisément, la technique LIBS implique la focalisation d'une impulsion laser vers la surface d'un échantillon du matériau à analyser, qui provoque la formation d'un micro-plasma. Ce micro-plasma se forme quasiment de façon immédiate, c'est-à-dire alors que l'impulsion laser n'est pas terminée. A la fin de l'impulsion laser, les espèces atomiques et ioniques du micro-plasma se désexcitent et réémettent alors un rayonnement qu'un analyseur, i.e. un spectromètre, capte et traduit afin d'obtenir un spectre décrivant les espèces chimiques qui composaient l'échantillon.

Ainsi, la technique LIBS peut permettre l'identification, grâce à la longueur d'onde d'émission, et la quantification, grâce à l'intensité d'émission, des composants présents dans le matériau à analyser. De plus, la technique LIBS permettant de réaliser une analyse à distance, elle s'avère tout particulièrement adaptée pour l'analyse des matériaux à l'état fondu à haute température, et notamment pour l'analyse du silicium en fusion, et l'analyse des matériaux ne pouvant pas être manipulés car représentant un danger potentiel. Aussi, dans le cas des métaux en fusion, tels que le silicium, la technique LIBS est susceptible de fournir en temps réel l'évolution de la composition chimique du matériau.

L'analyse par LIBS a déjà été proposée dans les documents WO 2004/001394 et WO 2015/177223 pour l'analyse d'un métal en fusion, par exemple du silicium, en vue par exemple de permettre un contrôle en continu des concentrations des impuretés contenues dans du métal en fusion lors d'un processus de purification du métal.

A la connaissance des inventeurs, la technique LIBS n'a toutefois jamais été mise en oeuvre, en association avec l'incorporation volontaire au silicium d'un ou plusieurs traceurs tels que définis précédemment, pour connaître l'avancement de la fusion dans un cycle d'élaboration d'un lingot par solidification dirigée par reprise sur germes.

Dans le cadre du procédé de l'invention, la technique LIBS, combinée à l'incorporation d'un ou plusieurs traceurs dans la charge et/ou les germes, permet d'identifier la présence dans le bain de silicium fondu, voire même la concentration, en traceurs, et donc le moment où le front de fusion atteint la position du ou desdits traceurs.

La technique LIBS autorise des niveaux de détection de l'ordre du ppm en poids pour les agents traceurs mis en oeuvre selon l'invention, en adéquation avec les applications envisagées pour le lingot de silicium, comme détaillé dans la suite du texte.

Le procédé selon l'invention permet avantageusement de s'affranchir de la méthode intrusive de palpage.

Par ailleurs, il permet de déterminer la position du front de fusion, en particulier la fin de fusion, avec une incertitude de mesure réduite comparativement à la méthode de palpage. Enfin, elle présente une bonne reproductibilité.

Selon un autre de ses aspects, l'invention concerne ainsi l'utilisation du procédé selon l'invention, pour détecter la fin de fusion d'un cycle d'élaboration d'un lingot par solidification dirigée par reprise sur germes, et en particulier pour automatiser l'arrêt du programme de fusion du four de solidification dirigée.

D'autres caractéristiques, variantes et avantages du procédé selon l'invention, et de sa mise en oeuvre pour automatiser la fin de fusion, ressortiront mieux à la lecture de la description, des exemples et des figures qui suivent, donnés à titre illustratif et non limitatif de l'invention.

Dans la suite du texte, les expressions « compris entre ... et ... », « allant de ... à ... » et « variant de ... à ... » sont équivalentes et entendent signifier que les bornes sont incluses, sauf mention contraire.

Sauf indication contraire, l'expression « comportant/comprenant un(e) » doit être comprise comme « comportant/comprenant au moins un(e) ».

Comme évoqué précédemment, le procédé de l'invention est mis en oeuvre pour suivre l'avancement de la fusion lors d'un cycle d'élaboration d'un lingot de silicium par reprise sur germes dans un dispositif classique de solidification dirigée.

D'une manière générale, et non détaillée dans la suite du texte, l'élaboration d'un lingot de silicium par solidification dirigée est opérée dans un four de solidification directionnelle.

Elle comprend le positionnement d'un ou plusieurs germes au fond d'un creuset, par exemple un creuset en silice ou en graphite, éventuellement recouvert d'une couche de SiC. Les creusets sont connus pour résister à un chauffage à des températures élevées adéquates pour obtenir le bain liquide.

Les germes peuvent être par exemple de forme pavé droit, de base carrée et rectangulaire, et former un pavage en fond du creuset sous la forme d'un quadrillage régulier. Ils présentent généralement une épaisseur comprise entre 10 et 40 mm, de manière à avoir une certaine marge de manoeuvre dans la fusion partielle des germes au début de la phase de solidification.

Il relève des connaissances générales de l'homme du métier d'adapter de manière adéquate les moyens et conditions opératoires du four de solidification directionnelle employé.

Le four utilisé peut être un four conventionnel de solidification dirigée, comme par exemple un four de cristallisation de type HEM (provenant du nom anglais « Heat Exchange Method ») ou de type Bridgman avec un chauffage fixe par le haut et les côté.

D'une manière générale, le déplacement de l'interface solide/liquide dans le creuset provient de la modulation de la chaleur délivrée et de la chaleur extraite dans les différentes parties du creuset. Différents moyens de chauffage (par exemple résistif ou inductif) ou d'extraction de la chaleur peuvent être utilisés.

### AGENTS TRACEURS

Comme évoqué précédemment, un ou plusieurs agents traceurs sont intégrés selon l'invention au niveau de la charge de silicium et/ou des germes de silicium mis en oeuvre pour l'élaboration du lingot de silicium par solidification dirigée.

Il est entendu que, dans la mesure où les agents traceurs se retrouvent, au moins en partie, dans le bain de silicium fondu, à l'issue de la fusion de la charge de silicium et fusion partielle des germes, leur nature et quantité mises en oeuvre sont ajustées de manière à obtenir, à l'issue de la solidification dirigée, les propriétés, en particulier en termes de dopage (par exemple de type n ou de type p) et de résistivité, souhaitées pour le lingot final.

On désigne par « lingot final », dans la suite du texte, le lingot obtenu à l'issue du cycle de solidification dirigée, autrement dit le lingot solidifié à partir de la charge fondue de silicium.

De fait, il est connu que l'ajout d'une impureté dans un lingot de silicium peut avoir une influence sur la qualité électronique, sur la résistivité et/ou sur la durée de vie des porteurs de charge.

D'un autre côté, il est classique d'opérer un dopage de la charge de silicium pour contrôler les propriétés électriques du lingot de silicium résultant. De fait, les teneurs en dopants de type p et de type n, typiquement en bore et en phosphore, gouvernent la résistivité du silicium.

La nature et les teneurs mises en oeuvre en agents traceurs selon l'invention sont choisies de manière appropriée en considération du lingot final souhaité.

Plus particulièrement, les agents traceurs selon l'invention peuvent être choisis parmi :
- les agents dopants de type n ou de type p présentant un coefficient de partage dans le silicium inférieur ou égal à 10⁻¹ ;
- les éléments métalliques présentant un coefficient de partage dans le silicium très faible, en particulier inférieur ou égal à 10⁻⁴ ; et
- les éléments iso-électroniques du silicium, autrement dit les éléments de la colonne IV du tableau périodique des éléments, étain (Sn) et germanium (Ge).

Le « coefficient de partage » propre à une espèce donnée, noté « k » dans le texte, définit le ratio de la concentration de ladite espèce incorporée dans la phase solide et la concentration dans la phase liquide à l'interface solide/liquide.

Il appartient à l'homme du métier d'ajuster la quantité en agent(s) traceur(s) mis en oeuvre au niveau de la charge de silicium et/ou du ou des germes selon l'invention de manière à permettre leur détection par la technique LIBS dans le bain de silicium fondu.

En particulier, lorsque le procédé de l'invention est mis en oeuvre pour la détection de la fin de fusion, la quantité en agent traceur est ajustée de telle sorte que la teneur dudit agent traceur dans le bain fondu de silicium, lorsque le front de fusion a atteint la position d'arrêt souhaitée, excède le seuil de détection par LIBS dudit agent traceur.

Le seuil de détection par LIBS, propre à une espèce donnée, correspond à la valeur minimale de concentration dans le liquide à partir de laquelle il est possible de détecter la présence de ladite espèce.

Les agents traceurs mis en oeuvre selon l'invention, en particulier de type agents dopants de type n ou de type p, ou éléments iso-électroniques du silicium, présentent de préférence un seuil de détection par LIBS au moins de l'ordre du ppm, en particulier environ 1 ppm en poids, de préférence au moins de l'ordre du dixième de ppm, en particulier environ 0,1 ppm en poids.

Dans le cas de la mise en oeuvre d'agents traceurs de type éléments métalliques, le seuil de détection par LIBS peut être au moins de l'ordre de la dizaine de ppm (en particulier environ 10 ppm en poids), de préférence de l'ordre de 0,3 ppm en poids.

Un tel seuil de détection par la technique LIBS autorise la mise en oeuvre d'une quantité en agent(s) traceur(s) non préjudiciable aux propriétés du lingot final qui incorpore au moins en partie le ou lesdits agents traceurs mis en oeuvre.

Typiquement, les quantités en agent(s) traceur(s) mises en oeuvre dans la charge et/ou les germes sont telles qu'à l'issue du processus de fusion, le bain de silicium fondu comprend entre 0,1 et 100 ppm en poids, en particulier entre 0,3 et 10 ppm en poids d'agent(s) traceur(s).

Selon un premier mode de réalisation, le ou lesdits traceurs sont choisis parmi les agents dopants de type n ou de type p du silicium présentant un faible coefficient de partage, en particulier un coefficient de partage inférieur ou égal à 10⁻¹.

Plus particulièrement, le ou lesdits traceurs selon l'invention peuvent être choisis parmi les agents dopants de type p à faible coefficient de partage, tels que l'aluminium (Al), le gallium (Ga), l'indium (In), et les agents dopants de type n à faible coefficient de partage, tels que l'antimoine (Sb) et le bismuth (Bi).

De préférence, les agents traceurs sont choisis parmi Gallium, Indium et Antimoine.

De manière avantageuse, de tels éléments seront aisément détectables par la technique LIBS dans le bain de silicium fondu, tout en ayant peu ou pas d'impact sur la qualité du lingot final.

De fait, comme illustré en exemples 2 et 3, la présence dans le lingot final du ou desdits traceurs de type dopants de type n ou de type p peut être par exemple compensée en ajustant le dopage de type opposé au traceur de la charge initiale de silicium, de manière à conserver la résistivité souhaitée pour le lingot de silicium final.

En alternative, il est possible de tirer profit de la mise en oeuvre d'un ou plusieurs traceurs de type agent dopant n ou p selon l'invention pour obtenir, à l'issue de la fusion, un bain de silicium fondu comprenant le ou lesdits agents traceurs dopants de type p et/ou de type n à la teneur adéquate pour conduire au dopage et à la résistivité souhaités pour le lingot final.

Par exemple, la mise en oeuvre d'un traceur de type agent dopant p peut permettre avantageusement de stabiliser la résistivité du lingot final dans le cadre de la mise en oeuvre d'une charge de silicium dite « compensée » comprenant à la fois des agents dopants de type p et de type n (typiquement bore/phosphore), par exemple de type silicium métallurgique.

La valeur cible de résistivité est choisie en fonction des applications envisagées pour le lingot de silicium, par exemple entre 0,5 Ω.cm et 10 Ω.cm pour la fabrication de cellules photovoltaïques.

Typiquement, la quantité en traceur(s) de type agent(s) dopant(s) de type n ou de type p, mis en oeuvre selon l'invention, est telle que la teneur en traceurs dans le bain de silicium fondu, à l'issue de l'arrêt de la fusion, est comprise entre 0,1 et 100 ppm en poids (encore noté « ppmw »), en particulier entre 0,3 et 10 ppm en poids.

Selon un autre mode de réalisation particulier, le ou lesdits traceurs sont choisis parmi les éléments métalliques présentant un coefficient de partage dans le silicium inférieur ou égal à 10⁻⁴, de préférence inférieur ou égale à 10⁻⁵.

Dans le cas de la mise en oeuvre, par exemple au niveau de la charge initiale de silicium, d'un traceur de type élément métallique sous forme de matériau pur, ledit élément métallique est plus particulièrement choisi parmi les éléments présentant une température de fusion supérieure ou égale à 1414°C.

Un tel critère n'est pas indispensable dans le cas de la mise en oeuvre d'un traceur de type élément métallique sous forme de silicium dopé avec ledit traceur.

En particulier, le traceur peut être choisi parmi le tantale (Ta), le zirconium (Zr), l'osmium (Os), le scandium (Sc), le ruthénium (Ru), le molybdène (Mo), le Niobium (Nb), le nickel (Ni), le tungstène (W) et leurs mélanges.

De préférence, l'agent traceur est le tungstène.

De préférence, comme évoqué précédemment, les éléments métalliques mis en oeuvre en tant que traceurs présentent avantageusement un seuil de détection par la technique LIBS au moins de l'ordre de la dizaine de ppm (en particulier environ 10 ppm en poids), de préférence de l'ordre de 0,3 ppm en poids.

De manière avantageuse, la quantité en traceurs de type élément métallique mis en oeuvre selon l'invention est telle que la teneur en traceurs dans le bain de silicium fondu, à l'issue de l'arrêt de la fusion, est la plus faible possible autorisant sa détection par LIBS.

Ainsi, la quantité en traceur(s) incorporée à la charge et/ou aux germes de silicium est telle que la teneur dans le bain de silicium fondu à l'issue de l'arrêt de la fusion est légèrement supérieure au seuil de détection dudit agent traceur par la technique LIBS.

Comme illustré dans l'exemple 4 qui suit, l'ajout d'un tel traceur à l'image du tungstène, a peu, voire pas, d'impact sur le lingot final. De fait, en raison du très faible coefficient de partage de l'élément métallique mis en oeuvre en tant que traceur, le traceur ségrége très bien lors de la cristallisation du lingot de silicium, seule la dernière fraction solidifiée, éliminée ultérieurement par découpe du haut du lingot, étant enrichie en traceur.

Ce phénomène de ségrégation est bien connu et classiquement mis en oeuvre dans des techniques de purification par solidification dirigée des charges de silicium métallurgique.

Ainsi, le lingot final ne comprend pas, ou uniquement sous forme de traces, le traceur de type élément métallique mis en oeuvre.

Selon encore un autre mode de réalisation particulier, il est possible de choisir les traceurs parmi les éléments de la colonne IV du tableau périodique, spécifiquement le germanium (Ge) et l'étain (Sn).

Ces éléments, iso-électroniques du silicium, auront avantageusement peu ou pas d'influence sur la qualité électronique du lingot final.

De préférence, l'agent traceur est choisi parmi le germanium (Ge) et l'étain (Sn).

Typiquement, la quantité en traceurs de type éléments iso-électroniques du silicium, mis en oeuvre selon l'invention, est telle que la teneur en traceurs dans le bain de silicium fondu, à l'issue de l'arrêt de la fusion, est comprise entre 0,1 et 100 ppm en poids, en particulier entre 0,3 et 10 ppm en poids.

De préférence, les agents traceurs mis en oeuvre selon l'invention sont choisis parmi le gallium, l'indium, l'antimoine ; le tungstène ; le germanium et l'étain.

En particulier, les agents traceurs mis en oeuvre selon l'invention sont choisis parmi le gallium, l'indium, le tungstène, le germanium et l'étain.

Bien entendu, il est possible de mettre en oeuvre plusieurs agents traceurs selon l'invention, en particulier lorsqu'ils sont positionnés à la fois au niveau des germes et de la charge de silicium, ou encore en différentes positions données de la charge de silicium.

### Positionnement des agents traceurs

Selon une première variante du procédé de l'invention, le traceur est incorporé au niveau du ou desdits germes de silicium.

Une telle variante de réalisation est illustrée dans l'exemple 1 (germes dopés avec du germanium) et l'exemple 2 (germes dopés au gallium) qui suivent.

Le procédé de l'invention permet avantageusement d'identifier l'arrivée du front de fusion au niveau des germes.

L'incorporation du ou des traceurs au niveau d'un ou plusieurs germes est ainsi particulièrement adaptée pour la détection de la fin de fusion du cycle d'élaboration du lingot, autrement dit la position du front de fusion souhaitée pour l'arrêt du programme de fusion du four.

De fait, comme évoqué précédemment, il est souhaitable, lors de la solidification dirigée par reprise sur germes, de maîtriser l'épaisseur de germe(s) fondue, avant d'initier la solidification du silicium.

L'épaisseur des germes s'entend de l'épaisseur des germes suivant l'axe (Z) longitudinal du creuset.

L'axe (Z) longitudinal du creuset désigne la ligne joignant l'ensemble des barycentres des sections transversales dudit creuset (parois du creuset inclus). L'axe longitudinal peut être plus particulièrement un axe de symétrie pour le creuset.

Par exemple, il peut être avantageux de fondre uniquement le ou lesdits germes sur une épaisseur donnée permettant de s'affranchir des défauts de la partie supérieure des germes.

Dans le cadre du procédé de l'invention, lorsque le front de fusion atteint le ou lesdits germes incorporant au moins un traceur, la fusion partielle du ou des germes génère la présence dans le bain de silicium fondu du traceur. La technique LIBS permet d'apprécier la présence, et plus précisément la teneur, des traceurs présents dans le bain liquide.

Il est ainsi possible d'identifier le moment où le front de fusion atteint le ou lesdits germes, et plus précisément de déduire *via* la quantification par analyse LIBS du ou des agents traceurs, l'épaisseur fondue du ou des germes.

De manière avantageuse, le processus de fusion peut être stoppé (de manière manuelle ou automatisée) à la position souhaitée du front de fusion, lorsque la présence, voire une quantité donnée, en traceurs est détectée par la mesure par LIBS dans le bain de silicium fondue.

Selon une autre variante de réalisation du procédé de l'invention, le ou lesdits traceurs peuvent être incorporés en une ou plusieurs positions données à la charge initiale de silicium.

La préparation de la charge de silicium mise en oeuvre selon l'invention relève des connaissances générales de l'homme du métier. Elle peut être constituée de silicium sous diverses formes, par exemple cailloux de silicium, microbilles de silicium, plaquettes de silicium, éventuellement dopé de type n et/ou p, usuellement mis en oeuvre pour la solidification dirigée d'un lingot de silicium

La charge de silicium peut en particulier comprendre, outre éventuellement un ou plusieurs traceurs selon l'invention, un ou plusieurs agents dopants de type p et/ou de type n classiquement mis en oeuvre pour obtenir le dopage souhaité pour le lingot de silicium.

Le traceur peut être intégré à la charge initiale de silicium, sous forme de matériau pur ou de silicium dopé avec ledit traceur. Il peut se présenter sous diverses formes, par exemple sous forme de poudres, de billes, de fils et/ou de plaquettes.

De préférence, les traceurs introduits selon l'invention présentent une pureté élevée pour éviter toute contamination indésirable du silicium.

Différentes variantes de positionnement du ou desdits traceurs au niveau de la charge de silicium sont envisageables, notamment au regard des informations de l'avancement de la fusion dont on souhaite tirer profit pour optimiser le cycle de solidification dirigée.

Dans la suite du texte, la position d'un agent traceur dans la charge de silicium est plus particulièrement repérée par rapport la distance (également désignée comme la hauteur) de l'agent traceur par rapport au fond du creuset, mesurée selon l'axe (Z) longitudinal du creuset.

Ainsi, un ou plusieurs agents traceurs peuvent être incorporés à la charge de silicium à une ou plusieurs hauteurs prédéfinies par rapport au fond du creuset, mesurées selon l'axe (Z) longitudinal du creuset.

Selon un mode de réalisation particulier, comme illustré en exemples 3 et 4 qui suivent, la position de l'agent traceur est ajustée de manière à correspondre à la position du front de fusion à laquelle le programme de fusion du four de solidification dirigée doit être stoppé.

La détermination de la position du front de fusion à laquelle le programme de fusion du four doit être stoppé relève des compétences de l'homme du métier au regard du four/recette employés, et en prenant notamment en considération l'inertie de fusion (qui traduit le déplacement du front de fusion lors du changement des consignes de fusion vers solidification), pour l'arrêt effectif du front de fusion à la hauteur souhaitée (autrement dit pour une épaisseur souhaitée de germes fondue).

Ainsi, la position du front de fusion à laquelle le programme de fusion du four de solidification dirigée doit être stoppé peut être prédéterminée au regard de l'épaisseur souhaitée de germes fondue et de l'inertie de fusion.

Par exemple, l'inertie de fusion peut être évaluée lors d'un essai de solidification dirigée préalable, mettant en oeuvre une même recette de pilotage du four.

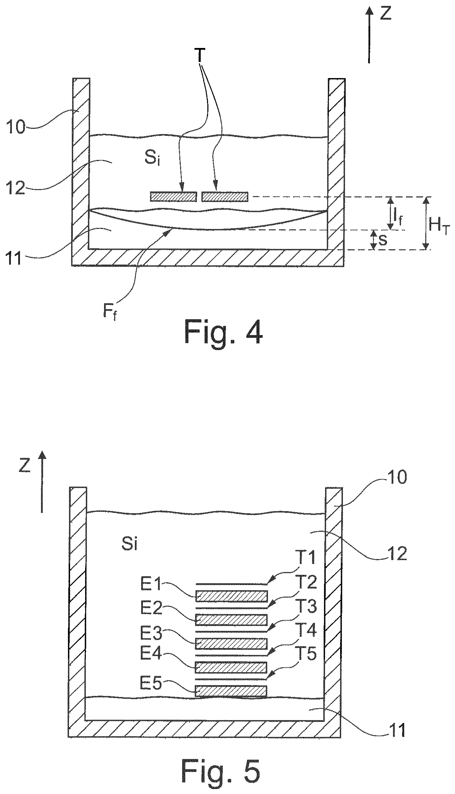

Sans vouloir être lié par la théorie, comme représenté en figure 4, le traceur peut être ainsi positionné à une hauteur H_{T} du fond de creuset correspondant à la hauteur d'arrêt souhaitée (« S ») du front de fusion à laquelle est ajoutée l'inertie de fusion (« If »).

De manière similaire au cas de la mise en oeuvre du traceur au niveau des germes, il est ainsi possible de stopper (de manière manuelle ou automatisée) le processus de fusion à la position souhaitée du front de fusion, lorsque la présence, voire une quantité donnée, en traceurs est détectée par la mesure par la technique LIBS dans le bain de silicium fondue.

Selon encore un autre mode de réalisation particulier, des traceurs, de même nature ou de nature différente, peuvent être présents en plusieurs positions données de la charge de silicium.

L'appréciation de la présence (dans le cas de la mise en oeuvre de traceurs différents), et/ou la quantification (dans le cas de traceurs de même nature) par la technique LIBS des traceurs dans le bain fondu de silicium au cours de la fusion de la charge permet de déduire par exemple la vitesse de fusion (vitesse de progression du front de fusion).

Selon encore un autre mode de réalisation particulier, un ou plusieurs traceurs peuvent être présents en une ou plusieurs positions données dans la charge de silicium, en particulier dans la partie haute de la charge de silicium.

L'appréciation par la technique LIBS de la teneur en agents traceurs dans le bain de silicium permet de déduire, en connaissance de la quantité en traceurs initialement introduits dans la charge, l'évolution du volume du bain fondu au cours de la fusion, et donc de manière indirecte l'avancement de la fusion.

Il est encore possible, à partir de la connaissance de l'avancement de la fusion, d'optimiser le processus de fusion lors du cycle d'élaboration par solidification dirigée du lingot de silicium.

Par exemple, un traceur peut être incorporé à la charge de silicium, à une hauteur H_{T}' légèrement supérieure à la hauteur H_{T} correspondant à la position du front de fusion à laquelle le programme de fusion doit être stoppé.

Dès lors, la détection au cours de la fusion de la présence du traceur dans le bain fondu par la technique LIBS annonce que la position d'arrêt du processus de fusion est bientôt atteinte. Il peut être alors avantageux, lors la détection par LIBS de la présence de l'agent traceur dans le bain fondu, de réduire la vitesse de fusion, en vue de minimiser la consommation des germes.

Il est entendu que les différentes variantes et modes de réalisation décrits ci-dessus peuvent être combinés.

En particulier, des traceurs, notamment de différentes natures, peuvent être incorporés à la fois au niveau de la charge de silicium, et au niveau du ou desdits germes.

Bien entendu, l'invention n'est pas limitée aux modes de réalisation particuliers évoqués ci-dessus. Diverses modifications peuvent y être apportées par l'homme du métier, notamment en vue d'accéder aux informations souhaitées de l'évolution du front de fusion lors du processus d'élaboration du lingot par reprise sur germes.

### Mesure LIBS

Comme évoqué précédemment, l'invention tire profit de la technique de spectroscopie sur un plasma induit par laser, plus connue sous l'abréviation « LIBS », pour permettre une détection, et même une quantification du ou des traceurs, en particulier tels que décrits précédemment, dans le bain liquide de silicium.

La technique LIBS peut être par exemple mise en oeuvre à l'aide d'un dispositif tel que proposé dans les documents WO 2004/001394 et WO 2015/177223 et particulièrement adapté pour l'analyse en ligne par LIBS d'un bain de silicium fondu.

De manière classique, les moyens d'analyse par technique LIBS peuvent comporter un laser apte à générer une impulsion laser vers la surface à analyser dudit bain fondu de silicium, un jeu de miroirs permettant la focalisation de l'impulsion laser vers la surface à analyser, un télescope relié à une fibre optique permettant la collecte des émissions du micro-plasma formé par l'impulsion laser, et un spectromètre d'émission permettant l'analyse des émissions collectées.

La mesure par LIBS peut être effectuée *via* un accès optique ou *via* une canne de soufflage d'un gaz inerte, typiquement d'argon, positionné(e) à la surface du bain en fusion.

Le soufflage de gaz inerte permet d'éviter d'éventuelles contaminations de la surface à analyser du bain du silicium en fusion. Le soufflage de gaz inerte peut également présenter l'avantage d'augmenter les limites de détection de l'analyse par la technique LIBS.

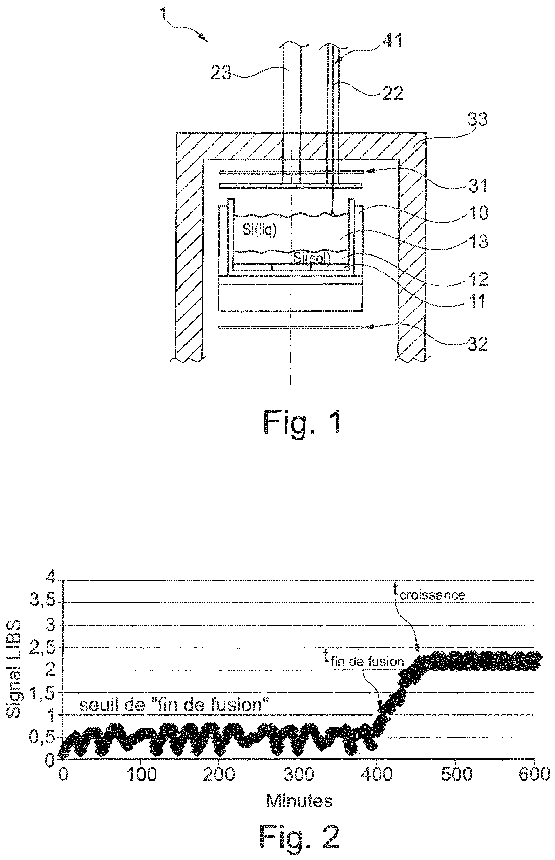

La mesure LIBS peut être intégrée dans le flux d'argon standard Ar(1) typiquement mis en oeuvre dans les dispositifs de solidification dirigée par reprise sur germes, ou *via* un canne d'argon additionnelle Ar(2), comme représenté en figure 1.

Le dispositif de mesure peut en outre comprendre des moyens de brassage mécanique rotatif du bain liquide, comme décrit dans le document WO 2015/177223, pour favoriser la stabilisation de la surface à analyser du bain fondu.

Selon encore une autre variante de réalisation, l'équipement de mesure par LIBS peut être mobile pour suivre l'évolution de la fusion pour plusieurs fours dans une configuration de production industrielle.

Il est entendu que la mesure par LIBS est initiée après un laps de temps donné pour permettre l'établissement d'une phase silicium liquide (ou fondu) en surface de la charge de silicium dans le creuset. Ce laps de temps peut être estimé par la connaissance de la recette de pilotage du four de solidification dirigée employé, ou encore identifié par mesure pyrométrique.

De préférence, la mesure en étape (ii) par la technique LIBS de la composition du bain fondu peut être effectuée en continu. De par la rapidité d'acquisition des données par la technique LIBS, il est possible de suivre en temps réel l'évolution de la composition chimique du bain liquide, et en particulier de suivre en continu la présence ou la teneur en traceurs dans le bain de silicium lors de la fusion.

Le procédé peut comporter l'affichage d'un signal, par exemple calibré en ppm en poids comme illustré en figure 2, représentatif de l'évolution de la teneur en traceur(s) dans le bain fondu au cours de la fusion.

Comme évoqué précédemment, le procédé de l'invention s'avère particulièrement utile pour la détection de la fin de fusion, autrement dit pour identifier le moment où le programme de fusion du four doit être stoppé.

L'arrêt du processus de fusion et le déclenchement de la cristallisation du lingot peuvent être opérés en mode manuel ou automatisés, au regard des informations obtenues par la technique LIBS.

De manière avantageuse, le procédé de l'invention permet d'automatiser la fin de fusion du cycle d'élaboration du lingot, autrement dit de programmer l'arrêt automatique du programme de fusion.

Plus spécifiquement, l'arrêt du programme de fusion du cycle d'élaboration par solidification dirigée peut être programmé lorsque la mesure par LIBS atteint une limite prédéfinie, correspondant à la détection d'une quantité donnée en traceur(s) dans le bain fondu.

Cette valeur limite de fin de fusion peut être prédéterminée par l'homme du métier, en considération du positionnement et de la quantité de traceurs mis en oeuvre et des paramètres de la recette/four employés, reproductibles d'un cycle de solidification dirigée à l'autre (comme par exemple l'inertie de fusion), comme illustré dans les exemples qui suivent.

L'utilisation du procédé de l'invention permet avantageusement d'optimiser le processus d'élaboration des lingots par reprise sur germes, notamment en ce qu'il permet de minimiser la consommation du ou des germes mis en oeuvre. Ceci s'avère particulièrement avantageux dans le cadre du recyclage des germes.

Bien entendu, l'invention n'est pas limitée aux variantes de réalisation décrites ci-dessus.

L'invention va maintenant être décrite au moyen des exemples et figures suivants, donnés à titre illustratif et non limitatif de l'invention.

### Figures

Figure 1 : Représentation schématique, en coupe transversale, du dispositif de solidification dirigée mis en oeuvre en exemple 1 ;
Figure 2 : Représentation schématique du signal LIBS calibré en ppm (en poids) associé aux segments 6, 7, 8 et 9 de la recette de pilotage du four de solidification dirigée selon l'exemple 1 ;
Figure 3 : Simulation des variations de la résistivité du lingot de silicium en fonction de la fraction solidifiée, dans le cas d'un lingot ML-Si avec dopage au bore (figure 3(a)) et dans le cas d'un ligot ML-Si avec dopage au bore et dopage au gallium (issu du dopage des germes au Ga) selon l'exemple 2 ;
Figure 4 : Représentation schématique, en coupe transversale, du positionnement des traceurs T d'antimoine dans la charge de silicium (12) selon l'exemple 3 ; et
Figure 5 : Représentation schématique, en coupe transversale, du positionnement des traceurs T1, T2, T3, T4 et T5 de tungstène dans la charge de silicium (12) selon l'exemple 4.

Il convient de noter que, pour des raisons de clarté, les différents éléments sur les figures 1, 4 et 5 sont représentés en échelle libre, les dimensions réelles des différentes parties n'étant pas respectées.

### EXEMPLES

Les exemples suivants sont des modélisations d'adaptation des recettes de pilotage de cycles d'élaboration de lingots de silicium en four de solidification dirigée, en particulier de l'automatisation de la transition fusion/cristallisation, à partir des données obtenues par la technique LIBS selon l'invention.

Ces exemples ne prennent pas en considération le temps pour l'homogénéisation du traceur dans le bain fondu. Ce temps caractéristique d'homogénéisation peut être intégré à l'inertie de fusion expérimentale postulée, reproductible d'un cycle à l'autre.

### EXEMPLE 1

### Automatisation de la fin de fusion à l'aide de germes dopés au germanium

### Dispositif de solidification dirigée par reprise sur germes

Le dispositif de solidification dirigée mis en oeuvre est décrit en référence à la figure 1.

4,536 kg de germes (11) de silicium Cz dopé à 1.10¹⁸ cm⁻³ avec du germanium (k_{Ge}=0,33) sous la forme de 4 germes (dimensions : 15,6 x 15,6 x 2 cm³). Ces germes sont déposés au fond d'un creuset (10), juxtaposés au centre.

55,464 kg de silicium charge de haute pureté (> 9 N) sont positionnés sur ces germes dans le creuset.

Un dopage au bore est apporté par l'ajout de 34,7 g de plaquettes de silicium déposées à environ 2/3 de hauteur de la charge et dopées avec du bore à une concentration de 1,62.10¹⁹ cm⁻³.

Le four employé (33) est un four classique pour la solidification dirigée du silicium, permettant des régulations de température avec des éléments chauffants (haut (31) et bas (32)) et une pression partielle d'argon.

Le déclenchement de la mesure LIBS est piloté par le four après un temps de segment, ou associé à la présence de liquide par mesure pyrométrique.

La mesure LIBS est opérée *via* une canne de soufflage (22) d'argon positionnée à la surface du bain en fusion. Le dispositif d'analyse par LIBS (41) peut être par exemple tel que décrit dans le document WO 2015/177223.

Le signal LIBS est envoyé au contrôleur four.

Contrairement à une reprise sur germes classique, il n'y a pas besoin de prendre une référence initiale de la position de la surface des germes par rapport à un référentiel four par palpage à la surface des germes (côte zéro utilisée pour la référence lorsque la gestion est réalisée par canne de palpage en cours de fusion).

### Pilotage de la transition fusion/cristallisation

Le déroulement du cycle de fusion/cristallisation du silicium par reprise sur germes est le suivant :
- Les étapes de mise sous vide du four, de chauffe initiale jusqu'à la température de rentrée de l'argon (600 mbar) et de chauffe jusqu'à la température de fusion du silicium sont inchangées par rapport à un processus classique de solidification dirigée.
- Le tableau 1 suivant fournit les valeurs de consigne à partir du pallier de fusion. Les consignes du palier de fusion (segment 6) sont inchangées.

En revanche, le palier de fusion est désormais associé à une fonction spéciale « fin de fusion ». La fonction spéciale « fin de fusion » enregistre une valeur en temps réel issue de la mesure LIBS.

Le signal LIBS est proportionnel à la quantité de germanium détecté dans le bain liquide. Il peut être par exemple calibré en ppm en poids (ppmw) comme illustré en figure2, ou rester sans unité.

Pour permettre à l'opérateur de vérifier la validité de la mesure sur l'interface homme/machine du four, il est possible par exemple de visualiser l'évolution du signal LIBS en fonction du temps.
- La fonction « fin de fusion » génère l'appel de l'opérateur pour validation de la fin de fusion. La fin de fusion génère le passage du segment 6 au segment 7. Si l'opérateur ne valide pas dans les 3 minutes, le passage du segment 6 au segment 7 est automatique.

Après 408 minutes de segment 6, le seuil préétabli correspondant à 1 ppmw de Ge dans le liquide est atteint. L'opérateur attend 2 minutes la confirmation d'un signal supérieur au seuil et valide la fin de fusion 410 minutes après le début du segment 6 (figure 2), par exemple en appuyant sur la fonction « OK » du message de l'interface homme/machine.

Cet instant est noté « t_{fin de fusion} » sur la figure 2. A ce stade, la fusion des germes a commencé.

Le signal LIBS est à 1 ppmw, ce qui permet de déduire qu'une portion proche de 20 % des germes a fondu au temps t_{fin de fusion}, soit en moyenne une épaisseur fondue des germes de 4 mm.

Pendant le déroulement du segment 7, la fusion continue jusqu'au début du segment 8. Ce temps est appelé t_{croissance} en figure 2.

A ce stade, la fusion des germes a stoppé.

Le signal LIBS est maximal autour de 2,2 ppmw, ce qui indique qu'une portion proche de 45 % des germes a fondu au temps t_{croissance}, soit en moyenne une épaisseur fondue de 9 mm. L'inertie de fusion, définie comme le déplacement de l'interface solide/liquide entre t_{fin de fusion} et t_{croissance}, est donc de 5 mm. Après une phase où ni fusion ni croissance n'est observée (fin du segment 8), la solidification (segment 9) est amorcée.

**Tableau 1 : Exemple de recette (non exhaustive) du four pour la transition fusion/cristallisation**

| **N° segment** | **Description** | **Rampe ou palier** | **Consigne plafond (°C)** | **Consigne sole (°C)** | **Temps (min)** | **Fonction spéciale** |
|---|---|---|---|---|---|---|
| 6 | Palier de fusion | Palier | 1500 | 1400 | 600 | Fin de fusion LIBS |
| 7 | Transition 1 | Rampe | 1445 | 1200 | 60 | |
| 8 | Transition 2 | Rampe | 1445 | 1000 | 60 | |
| 9 | Solidification | Rampe | 1444 | 980 | 70 | |

### Résultat

Par la mesure LIBS associée à l'ajout de germanium dans les germes, la reprise sur germes peut être ainsi automatisée.

La mise en oeuvre du germanium en tant qu'agent traceur au niveau des germes n'a aucun impact en termes de qualité (durée de vie des porteurs de charge), de résistivité, et de propriétés chimique, excepté la présence d'environ 10¹⁶ at.cm⁻³ de germanium dans le lingot résultant.

### EXEMPLE 2

### Automatisation de la fin de fusion à l'aide de germes dopés au gallium

### Dispositif de solidification dirigée par reprise sur germe

42,5 kg de germes recyclés d'un lingot Cz de silicium mono-like (ML) sont disposés comme pour l'exemple 1 en fond de creuset, soit sous forme de 25 germes de dimensions 15,6 x 15,6 x 3 cm³, soit sous forme d'un pavage complet recyclé 78 x 78 x 3 cm³.

Les germes Cz, initialement de 30 mm d'épaisseur, sont dopés à 7.10¹⁸ cm⁻³ en gallium.

410 kg de silicium charge de haute pureté (> 9 N) sont positionnés sur ces germes dans le creuset.

Un dopage au bore est apporté par l'ajout de 31 mg de poudre de bore pur au milieu de la charge de silicium.

Le four employé est de capacité G5. Il possède trois zones de chauffe (plafond, latéral, sole). La mesure LIBS a été intégrée comme pour l'exemple 1 au-dessus du coin du lingot à 100 mm des bords du creuset.

### Pilotage de la transition fusion/cristallisation

Le déroulement du cycle de fusion/cristallisation du silicium par reprise sur germes est le suivant :
- Les étapes de mise sous vide du four, de chauffe initiale jusqu'à la température de rentrée de l'argon (600 mbar) et de chauffe jusqu'à la température de fusion du silicium sont inchangées par rapport à un processus classique de solidification dirigée.
- La fonction spéciale « fin de fusion » est activée pour le palier de fusion. Cinq heures après le début de fusion, la mesure LIBS est lancée (temps correspond à l'établissement du liquide en surface de la charge en fusion).

Lorsque 1 mm de germe Cz résiduel est fondu sur toute la surface, environ 1,4 kg de germe dopé Ga sont mélangés au silicium liquide, générant une contamination de 1,2 ppmw environ du bain liquide. Cette contamination significativement supérieure à la limite de détection génère l'appel opérateur qui valide le saut au segment suivant et donc la fin de fusion automatisée.

L'inertie de fusion sur ce four/procédé a été optimisée pour être de 3 mm. De ce fait, 4 mm de germes Cz contaminés Ga sont fondus de manière homogène sur toute la surface (soit 5,7 kg), et la contamination du bain avant le début de croissance est de l'ordre de 4,7 ppmw.

### Résultat

Par mesure LIBS associée à l'ajout de gallium dans les germes, la reprise sur germes peut être automatisée.

La consommation des germes est réduite. La technique LIBS permet une détection rapide, et une bonne reproductibilité avec une faible quantité de germes fondus (dans le cas présent, 4 mm de germes sont consommés par cycle automatisé). Le nombre de recyclages des germes peut être ainsi plus important.

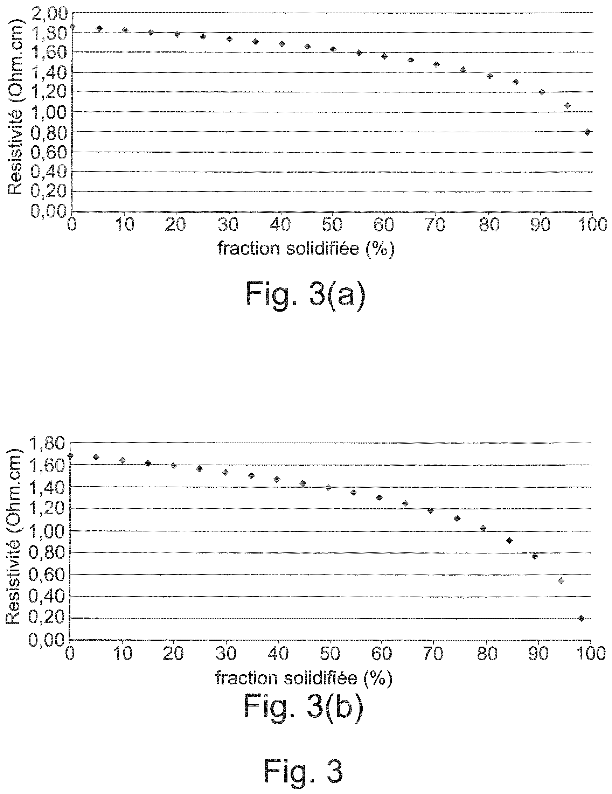

La concentration résiduelle en gallium dans le lingot final obtenu après solidification dirigée de la charge de silicium fondue impacte principalement la résistivité du haut du lingot, comme représenté en figure 3(b), comparativement à un lingot obtenu uniquement avec le dopage au bore (figure 3(a)).

Il est possible de minimiser cet impact en choisissant un agent traceur présentant un coefficient de partage k plus faible (par exemple In, Sb) ou un agent traceur non dopant (par exemple Ge, Sn).

Alternativement, il est possible de mettre en oeuvre le gallium comme agent traceur dans le cas d'une solidification dirigée d'un matériau compensé bore/phosphore de type silicium métallurgique, la présence de gallium (agent dopant de type p) dans le lingot final servant alors à obtenir la résistivité souhaitée.

### EXEMPLE 3

### Automatisation de la fin de fusion à l'aide d'un agent traceur (antimoine) positionné au niveau de la charge de silicium

### Dispositif de solidification dirigée par reprise sur germe

Le dispositif est décrit en référence à la figure 4.

450 kg de silicium (12) charge de haute pureté (> 9 N) sont positionnés dans un creuset (10). Le bas de la charge (silicium polycristallin à grains fins issu de la production du silicium par le procédé Siemens) sert de germe polycristallin (11).

Un dopage au bore est apporté par l'ajout de 37 mg de poudre de bore pur au milieu de la charge de silicium.

L'inertie de fusion (If), associée au couple four/recette (déplacement de l'interface solide/liquide entre t_{fin de fusion} et t_{croissance}) est de 12 mm (cette inertie peut être par exemple déterminée par une première expérience de ce type et la mesure expérimentale de l'épaisseur de germes résiduelle).

Le traceur est constitué de quatre plaquettes de base 156 x 156 mm² et d'épaisseur 1,125 mm de silicium dopé à 1.10¹⁹ cm⁻³ d'antimoine.

La côte d'arrêt du front de fusion souhaitée (« s » en figure 4) étant de 5 mm au-dessus du fond de creuset au centre du lingot, l'inertie de fusion If étant de 12 mm, les quatre plaquettes « traceur » sont juxtaposées au centre à H_{T}=17 mm du fond de creuset, comme représenté schématiquement en vue de coupe en figure 4.

Le four employé est de capacité G5. Il possède une zone de chauffe (plafond). La mesure LIBS a été intégrée dans le flux d'argon standard Ar(1) (représenté en figure 1), en remplacement du dispositif de palpage classique.

### Pilotage de la transition fusion/cristallisation

Le déroulement du cycle de fusion/cristallisation du silicium par reprise sur germes est le suivant :
- Les étapes de mise sous vide du four, de chauffe initiale jusqu'à la température de rentrée de l'argon (600 mbar) et de chauffe jusqu'à la température de fusion sont inchangées par rapport à un processus classique de solidification dirigée.
- La fonction spéciale « fin de fusion » est activée pour le palier de fusion. Cinq heures après le début de fusion, la mesure LIBS est lancée (temps correspondant à l'établissement du liquide en surface de la charge en fusion).

L'option détection > niveau de bruit est activée dans la fonction spéciale pour une détection rapide.
- Lorsque le front de fusion atteint et dépasse le traceur antimoine, le bain liquide est dopé à 0,53 ppmw de Sb suite à la fusion des 255 g de traceur.

Cette contamination significativement supérieure à la limite de détection par LIBS de 0,4 ppmw génère l'appel opérateur qui valide le saut au segment suivant et donc la fin de fusion automatisée comme dans l'exemple 2.

### Résultat

Par mesure LIBS associée à l'ajout d'antimoine au niveau de la charge de silicium, la reprise sur germes peut être automatisée.

Le dopage au bore (dopant de type p), qui est de 0,075 mg/kg pour la solidification d'un lingot sans ajout d'antimoine, a été légèrement augmenté à 0,09 mg/kg pour tenir compte de la présence de Sb, agent dopant de type n, dans le lingot final, afin de conserver la spécification de résistivité du lingot de 1 à 2 Ω.cm type p de l'exemple.

Dans le cas de l'élaboration d'un lingot de type n, la teneur en agent traceur antimoine pouvait être adaptée pour générer le lingot de type n souhaitée.

Le même exemple avec une même concentration en agent traceur de type Ga ou Ge ne nécessiterait aucun ajustement.

### EXEMPLE 4

### Automatisation de la fin de fusion avec l'aide d'un agent traceur (tungsten) positionné au niveau de la charge de silicium

### Dispositif de solidification dirigée par reprise sur germe

Le dispositif est décrit en référence à la figure 5.

800 kg de silicium (12) charge de haute pureté (> 9 N) sont positionnés dans le creuset (10). Le bas de la charge (silicium polycristallin à grains fins issu de la production du silicium par le procédé Siemens) sert de germe polycristallin (11).

Le dopage au bore est ajouté par l'ajout de 60 mg de poudre de bore pur au milieu de la charge de silicium.

5 traceurs (T1, T2, T3, T4 et T5) constitués de tungsten (W) pur sous forme de fil sont disposés à différentes hauteurs du bas du creuset, séparés verticalement par des espaceurs (E1, E2, E3, E4 et E5), permettant de maitriser le positionnement des traceurs au-dessus des germes (11) du fond du creuset, comme représenté schématiquement, en vue de coupe, en figure 5.

Dans l'exemple, les traceurs T1, T2 et T3 sont de morceaux de fils de 0,32 g et les traceurs T4 et T5 des morceaux de fils de 0,16 g.

Les espaceurs E1, E2, E3 et E4 sont de 1 cm d'épaisseur et sont constitués de tranches de lingots précédemment formés (chutes recyclées). L'épaisseur de l'espaceur E5 est de 4 mm pour ajuster une consommation de germes sous le traceur T5 de 2 mm en raison d'une inertie de fusion de 6 mm.

Le four utilisé est de capacité G6. Il possède une zone de chauffe (plafond). La mesure LIBS a été intégrée dans le flux d'argon standard Ar(1) en remplacement du dispositif de palpage classique. Un extracteur de chaleur à 4 positions d'ouvertures (Off=fermé ; On-1, On-2 et On-3) génère une extraction de flux de chaleur vers le bas du four.

### Pilotage de la transition fusion/cristallisation

Le déroulement du cycle de fusion/cristallisation du silicium par reprise sur germes est le suivant :
- Les étapes de mise sous vide du four, de chauffe initiale jusqu'à la température de rentrée de l'argon (600 mbar) et de chauffe jusqu'à la température de fusion sont inchangées par rapport à un processus classique de solidification dirigée.
- La fonction spéciale « fin de fusion » est activée pour le palier de fusion. Cinq heures après le début de fusion, la mesure LIBS est lancée (temps correspondant à l'établissement du liquide en surface de la charge en fusion).

L'option détection > niveau de bruit est activée dans la fonction spéciale pour une détection rapide.
- Lorsque le front de fusion atteint et dépasse respectivement les traceurs 1, 2, 3, 4 et 5, le bain liquide est progressivement dopé à 0,4 ppmw ; 0,8 ppmw ; 1,2 ppmw ; 1,4 ppmw et 1,6 ppmw. Cette contamination permet le suivi du front de fusion et de déduire la vitesse de fusion. Le traceur 5 déclenche le saut de segment du segment 6 vers le segment 7 de la recette du four résumée au tableau 2 suivant, par dépassement du seuil LIBS à 1,5 ppmw.

**Tableau 2 : Exemple de recette (non exhaustive) du four pour la transition fusion/cristallisation**

| **N° segment** | **Description** | **Rampe ou palier** | **Consigne plafond (°C)** | **Extraction de chaleur** | **Temps (min)** | **Fonction spéciale** |
|---|---|---|---|---|---|---|
| 6 | Palier de fusion | Palier | 1550 | Off | 600 | Fin de fusion LIBS |
| 7 | Transition 1 | Rampe | 1475 | On-1 | 60 | |
| 8 | Transition 2 | Rampe | 1445 | On-2 | 60 | |
| 9 | Solidification | Rampe | 1444 | On-3 | 70 | |

### Résultat

Par mesure LIBS associée à l'ajout de tungstène au niveau de la charge de silicium, la reprise sur germes peut être automatisée.

L'ajout de tungstène au niveau de la charge de silicium n'a pas d'impact sur le lingot final. En raison du très faible coefficient de partage du tungstène dans le silicium (2.10⁻⁸), le tungstène ségrége très bien, seule la dernière fraction solidifiée, éliminée par découpe du lingot est enrichie en tungstène.

## Revendications

1. Procédé utile pour suivre l'avancement de la fusion lors de l'élaboration d'un lingot de silicium par solidification dirigée par reprise sur germes, comprenant au moins les étapes consistant en :
(i) disposer, dans un creuset, d'une charge de silicium positionnée en surface d'un ou plusieurs germes en silicium ;
le ou lesdits germes, et/ou ladite charge de silicium en une ou plusieurs position(s) donnée(s), comportant un ou plusieurs éléments, dits agents traceurs, choisis parmi :
• les agents dopants de type n ou de type p présentant un coefficient de partage dans le silicium inférieur ou égal à 10⁻¹ ;
• les éléments métalliques présentant un coefficient de partage dans le silicium inférieur ou égal à 10⁻⁴ ; et
• les éléments, iso-électroniques du silicium, germanium (Ge) et étain (Sn) ;
(ii) apprécier, au cours de la fusion de la charge de silicium, la présence et/ou la quantité en agent(s) traceur(s) par une technique de mesure chimique de type spectroscopie sur plasma induit par laser (LIBS) à la surface du bain de silicium fondu ; et
(iii) déterminer, à partir de la ou des mesures LIBS, l'avancement de la fusion.

2. Procédé selon la revendication précédente, dans lequel le ou lesdits agents traceurs sont choisis parmi les agents dopants de type p de coefficient de partage dans le silicium inférieur ou égal à 10⁻¹, en particulier l'aluminium, le gallium, l'indium ; et les agents dopants de type n de coefficient de partage dans le silicium inférieur ou égal à 10⁻¹, en particulier l'antimoine et le bismuth, de préférence le ou lesdits agents traceurs sont choisis parmi Ga, In et Sb.

3. Procédé selon l'une quelconque des revendications précédentes, dans lequel le ou lesdits agents traceurs sont choisis parmi les éléments métalliques présentant un coefficient de partage dans le silicium inférieur ou égal à 10⁻⁴, en particulier inférieur ou égal à 10⁻⁵, et présentant, dans le cas de la mise en oeuvre du ou desdits agents traceurs de type élément métallique sous forme de matériau pur, une température de fusion supérieure ou égale à 1414 °C.

4. Procédé selon la revendication précédente, dans lequel le ou lesdits agents traceurs sont choisis parmi le tantale (Ta), le zirconium (Zr), l'osmium (Os), le scandium (Sc), le ruthénium (Ru), le molybdène (Mo), le Niobium (Nb), le nickel (Ni) et le tungstène (W), de préférence le tungstène (W).

5. Procédé selon l'une quelconque des revendications précédentes, dans lequel le ou lesdits agents traceurs sont choisis parmi le germanium (Ge) et l'étain (Sn).

6. Procédé selon l'une quelconque des revendications précédentes, dans lequel le ou lesdits agents traceurs sont choisis parmi le gallium, l'indium, le tungstène, le germanium et l'étain.

7. Procédé selon l'une quelconque des revendications précédentes, dans lequel le ou lesdits agents traceurs sont présents au niveau du ou desdits germes de silicium, ledit procédé étant plus particulièrement utile pour la détection de la fin de fusion du cycle d'élaboration du lingot.

8. Procédé selon l'une quelconque des revendications précédentes, dans lequel le ou lesdits agents traceurs sont incorporés à la charge de silicium à une ou plusieurs hauteurs prédéfinies par rapport au fond du creuset, mesurées selon l'axe (Z) longitudinal du creuset.

9. Procédé selon la revendication précédente, dans lequel le ou les agents traceurs sont incorporés à la charge de silicium sous forme de matériau pur ou de silicium dopé avec le ou lesdits traceurs, en particulier sous forme de poudre, de billes, de fils et/ou de plaquettes.

10. Procédé selon la revendication 8 ou 9, dans lequel la position d'au moins un agent traceur est ajustée pour correspondre à la position du front de fusion à laquelle le programme de fusion du four de solidification dirigée doit être stoppé.

11. Procédé selon la revendication précédente, dans lequel la position du front de fusion à laquelle le programme de fusion du four de solidification dirigée doit être stoppé est prédéterminée au regard de l'épaisseur souhaitée de germes fondue et de l'inertie de fusion.

12. Procédé selon l'une quelconque des revendications précédentes, dans lequel la mesure par LIBS est effectuée *via* un accès optique ou *via* une canne de soufflage d'un gaz inerte, en particulier d'argon, positionnée à la surface du bain en fusion.

13. Procédé selon l'une quelconque des revendications précédentes, dans lequel la mesure en étape (ii) par LIBS est opérée en continu.

14. Procédé selon la revendication précédente, comprenant l'affichage d'un signal, par exemple calibré en ppm en poids, représentatif de l'évolution de la teneur en traceur(s) dans le bain de silicium fondu au cours de la fusion.

15. Utilisation d'un procédé tel que défini selon l'une quelconque des revendications précédentes, pour la détection de la fin de fusion d'un cycle d'élaboration d'un lingot par solidification dirigée par reprise sur germes, en particulier pour automatiser l'arrêt du programme de fusion du four de solidification dirigée, l'arrêt du programme étant plus particulièrement programmé lorsque la mesure par LIBS atteint une limite prédéfinie, correspondant à la détection d'une quantité donnée en traceur(s) dans le bain fondu.
